# EUROPEAN PATENT APPLICATION

(11) **EP 0 878 762 A1**
(43) Date of publication of application: **18.11.1998**
(21) Application number: 98108539.2
(22) Date of filing: 11.05.1998
(51) Int. Cl.: G06F 11/263, G06F 17/50

(54) **Method and apparatus for converting test signals**

(30) Priority: 14.05.1997 JP 123982/97
(71) Applicant: NEC CORPORATION, Tokyo (JP)
(72) Inventor: Sato, Katsuya, Minato-ku, Tokyo (JP); Matsuo, Noriko, Minato-ku, Tokyo (JP)
(74) Representative: Baronetzky, Klaus, Dipl.-Ing.

(57) **Abstract**

A test bench converter comprising a waveform portion extracting unit (110) for extracting description about waveform portion upon receipt of a test bench description with operations corresponding to signal application to each terminal of a test circuit described by use of delay time, a waveform converting unit (120) for converting the waveform portion extracted by the waveform portion extracting unit (110) into a clock signal synchronized waveform, and a format creating unit (130) for creating and supplying a test bench description with operations corresponding to signal application to each terminal of the test circuit described in a clock signal synchronized way after attaching a necessary format to the waveform converted by the waveform converting unit (120).

## Description

### BACKGROUNDS OF THE INVENTION

### FIELD OF THE INVENTION

The present invention describes a technique for creating a test bench for supplying a test vector (test pattern) to a simulation device in case of logical verification for a semiconductor integrated circuit, and relates to a test bench converter and its converting method for converting a test bench described by use of delay time into a clock signal synchronized description format.

### DESCRIPTION OF THE RELATED ART

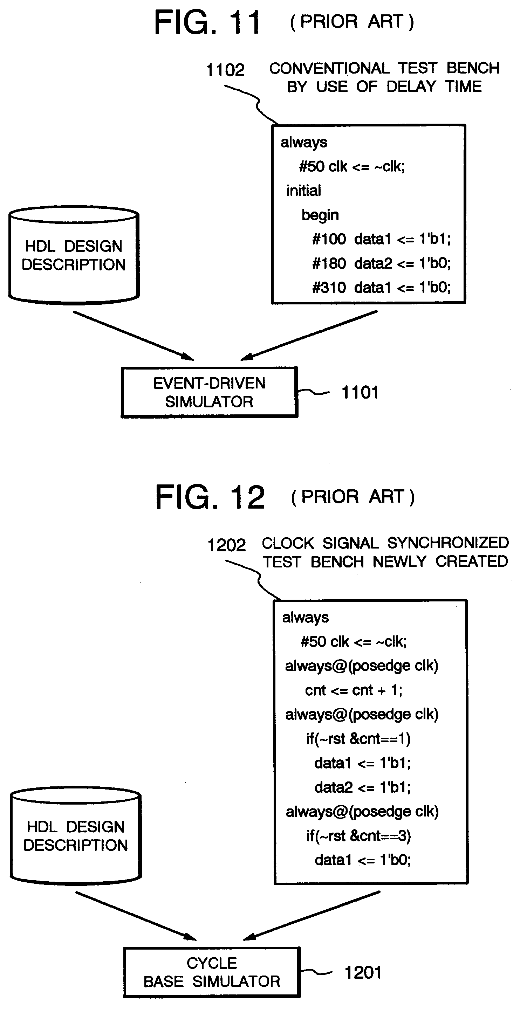

In case of logical verification for a semiconductor integrated circuit by use of a simulation device, a test vector 1001 is converted into a test bench 1002 described in a hardware description language, which is supplied to a simulation device 1003. At this time, the test bench 1002 is provided with a function of supplying the test vector 1001 to a circuit 1004 to be tested, as well as a function of making a comparison between the value described as the expected value within the test vector 1001 and the target output value if needs arises, as illustrated in Fig. 10.

Fig. 11 shows an example of the test bench description converted by the conventional test bench converting technique, indicating a test bench description method suitable for an event-driven simulator. As the conventional method of describing the change of signal values in a test bench 1102, there has been used a sequential description method of describing propagation timing of signal by use of delay time, as illustrated in Fig. 11. This is because the conventional processing by an event-driven simulator 1101, which has been chiefly used as a simulation device, is the sequential processing such as computing and storing input signal propagation in time order.

Recently, a logical verification system characterized by high speed processing has been developed, with enlargement of a semiconductor integrated circuit. This kind of verification system includes a cycle base simulator and a hardware emulator. The cycle base simulator is a simulation device capable of evaluating the state inside a circuit only by the change points of a clock signal for activating elements within the circuit, for the purpose of high speed processing. The hardware emulator is a simulation device in which a logically equivalent circuit as a circuit to be tested is built on hardware, thereby to perform evaluation on the hardware, for the purpose of high speed processing. These verification systems need a test bench description described in a way of synchronizing all the signal propagation timing with a clock signal, for the purpose of high speed processing, differently from the conventional sequential description by use of delay time.

Fig. 12 is a schematic view showing a test bench description to use in a logical verification system using a cycle base simulator, by way of example, by use of the Verilog-HDL, one of the hardware description language. It is needless to say that the similar test bench description described in synchronization with a clock signal is used also in case of using the hardware emulator as a logical verification system.

The point of finishing one cycle of a clock signal is defined as the minimum unit on the time axis in the operation of a cycle base simulator 1201 shown in Fig. 12. The operation in the minimum unit, or the change point of a clock signal is only the time subject to signal transfer. Therefore, unless the test bench to be used for verification is a test bench description which supplies to a test circuit a test vector such as may change the signal to be supplied to the other input terminal also at the timing of changing the clock signal it cannot be correctly evaluated. While, in the conventional event-driven simulator 1101, since its processing is the sequential one such as computing and storing the input signal propagation in time order as mentioned above, the test bench 1102 to be used for verification is sequentially described in time delay expression. In a word, the test bench 1202 for the cycle base simulator 1201 is described in a manner of synchronizing with a clock signal, while the test bench 1102 for the conventional event-driven simulator 1101 is described in an expression of sequential timing by use of delay time, and the both test benches 1102 and 1202 are not compatible with each other. Therefore, a designer performing logical verification with a cycle base simulator 1201 must create a clock signal synchronized test bench 1202 manually in addition to the existing test bench 1102.

As mentioned above, the test bench for use in the conventional event-driven simulator is described in an expression of sequential timing by use of delay time. Therefore, this test bench cannot be used for the logical verification in a verification system requiring a clock signal synchronized test bench, such as a cycle base simulator or a hardware emulator.

Therefore, a designer must create a new test bench or manually rewrite the existing test bench when a clock signal synchronized test bench is required, with a great consumption of time and labor. It takes much time in preparation for circuit verification, which results in increasing the verification time and prevents taking full advantage of high speed verification system.

### SUMMARY OF THE INVENTION

An object of the present invention is to provide a test bench converter and its converting method for converting a test bench described in an expression of sequential timing by use of delay time, into a clock signal synchronized description, so as to eliminate a designer's time and labor of creating a test bench, thereby performing logical verification of a semiconductor integrated circuit efficiently.

Another object of the present invention, in addition to the above object, is to provide a test bench converter and its converting method capable of preventing description errors in conversion by mechanical conversion of a test bench.

According to the first aspect of the invention, a test bench converter for creating a test bench described in a hardware description language for supplying a test vector to a simulation device of performing logical verification on a semiconductor integrated circuit by changing a description way of an existing test bench, comprises
waveform extracting means for extracting description about waveform upon receipt of a test bench description with operations corresponding to signal application to each terminal of a test circuit described by use of delay time,
waveform converting means for converting the waveform extracted by the waveform extracting means into a clock signal synchronized waveform, and
format creating means for creating and supplying a test bench description with operations corresponding to signal application to each terminal of the test circuit described in a clock signal synchronized way after attaching a necessary format to the waveform converted by the waveform converting means.

In the preferred construction, the waveform converting means comprises clock wave detecting means for detecting the waveform of a clock signal, of the waveform extracted by the waveform extracting means, waveform estimating means, upon detecting waveform to be converted corresponding to signal application to each terminal of the test circuit, for deciding how to conform the waveform with the waveform of the clock signal, and waveform creating means for creating a clock signal synchronized waveform based on the decision by the waveform estimating means.

In the preferred construction, the format creating means creates a counter for counting rise of a clock signal and creates a signal propagation description by use of the counter instead of delay time.

In another preferred construction, the waveform converting means comprises clock wave detecting means for detecting a waveform of a clock signal, of the waveform extracted by the waveform extracting means, waveform estimating means, upon detecting waveform to be converted corresponding to signal application to each terminal of the test circuit, for deciding how to conform the waveform with the waveform of the clock signal, and waveform creating means for creating a clock signal synchronized waveform based on the decision by the waveform estimating means, and
the format creating means creates a counter for counting rise of a clock signal and creates a signal propagation description by use of the counter instead of delay time.

According to the second aspect of the invention, a test bench converting method for creating a test bench described in a hardware description language for supplying a test vector to a simulation device of performing logical verification on a semiconductor integrated circuit by changing a description way of an existing test bench, comprising the steps of:
a step of extracting description about waveform upon receipt of a test bench description with operations corresponding to signal application to each terminal of a test circuit described by use of delay time,
a step of detecting the waveform of a clock signal, of the extracted waveform,
a step of deciding how to conform the waveform with the waveform of the clock signal, upon detecting the waveform to be converted corresponding to signal application to each terminal of the test circuit,
a step of creating a clock signal synchronized waveform based on the decision, and
a step of creating and supplying a test bench description with operations corresponding to signal application to each terminal of the test circuit described in a clock signal synchronized way after attaching a necessary format to the created waveform.

In the preferred construction, the format attaching step further comprises a step of creating a counter for counting rise of a clock signal, and a step of creating a signal propagation description by use of the counter instead of delay time.

Other objects, features and advantages of the present invention will become clear from the detailed description given herebelow.

### BRIEF DESCRIPTION OF THE DRAWINGS

The present invention will be understood more fully from the detailed description given herebelow and from the accompanying drawings of the preferred embodiment of the invention, which, however, should not be taken to be limitative to the invention, but are for explanation and understanding only.

In the drawings:
Fig. 1 is a block diagram showing the constitution of a test bench converter according to an embodiment of the present invention.
Fig. 2 is a flow chart showing the operation of the embodiment.
Fig. 3 shows a conversion example of a test bench description described by VHDL.
Fig. 4 shows a conversion example of a test bench description described by Verilog HDL.
Fig. 5 is a view showing the state of wave conversion and more specifically showing the state of conforming the change points of a signal with the clock signal rising-up positions.
Fig. 6 shows an example of creating a test bench description synchronized with a clock signal by use of a test bench description and a pattern description.
Fig. 7 is a view showing the state of wave conversion and more specifically showing the state of conforming the change points of a signal with the clock signal falling positions.
Fig. 8 is a view showing the state of conforming the change points of a test pattern described by use of delay time with the change points of a clock signal.
Fig. 9 is a view showing the state of conforming the change points of a test pattern described by use of delay time with the change points of a clock signal.
Fig. 10 is a schematic view showing the state of creating a test bench description from a test vector and supplying it to a simulation device.
Fig. 11 is a view showing the state of supplying a test bench description to an event-driven simulator.
Fig. 12 is a view showing the state of supplying a test bench description to a cycle base simulator.

### DESCRIPTION OF THE PREFERRED EMBODIMENT

The preferred embodiment of the present invention will be discussed hereinafter in detail with reference to the accompanying drawings. In the following description, numerous specific details are set forth in order to provide a thorough understanding of the present invention. It will be obvious, however, to those skilled in the art that the present invention may be practiced without these specific details. In other instance, well-known structures are not shown in detail in order to unnecessary obscure the present invention.

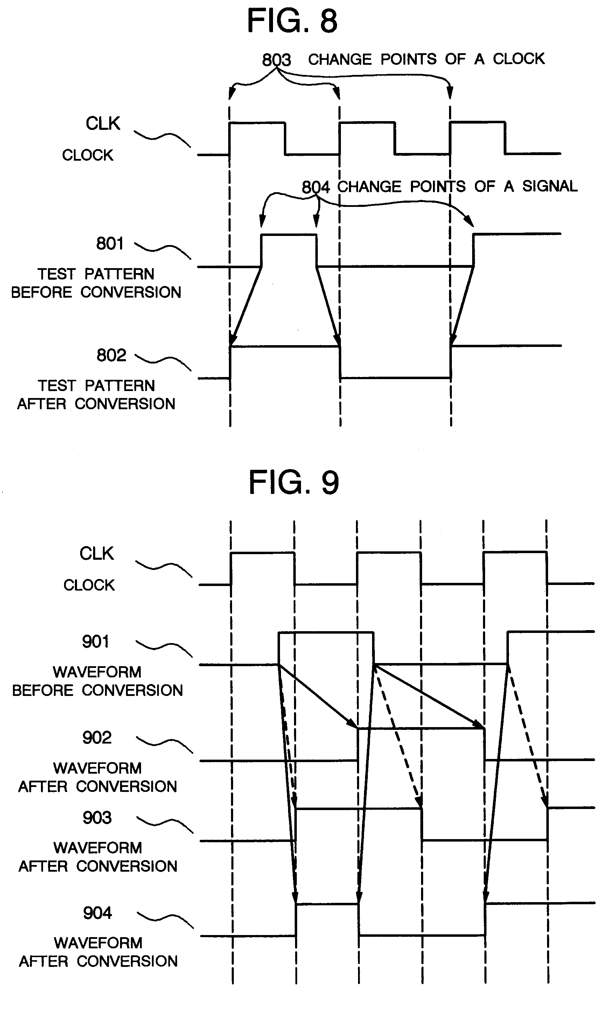

Referring to Figs. 8 and 9, the outline of test bench conversion processing according to the present invention will be described at first. As illustrated in Fig. 8, the present invention performs the conversion of a test bench into that one for supplying a clock signal synchronized input signal, by reading out the waveform information (test pattern) 801 of a test vector that is the description of the operation corresponding to signal application to each terminal of a circuit to be tested and generating a test pattern 802 so that the change points 804 of the wave may be in accord with the change points 803 of a clock signal CLK.

Fig. 9 shows three examples of methods for conforming the change points of the wave with the change points of a clock signal. Referring to Fig. 9, in a waveform 902 after conversion, the corresponding change points in a waveform 901 before conversion are conformed with the rising-up positions of a clock signal CLK immediately following the respective change points. In a waveform 903 after conversion, the corresponding change points in the waveform 901 before conversion are conformed with the falling positions of the clock signal CLK immediately following the respective change points. In a waveform 904 after conversion, the corresponding change points in the waveform 901 before conversion are conformed with the respectively closer change points, at the rising-up position or the falling position, of the clock signal CLK immediately before or after the respective change points. A designer can arbitrarily decide which corresponding change point of the waveform 901 before conversion should be conformed with which change point of the clock signal CLK. Further, a designer can freely set the change points of a clock signal to be conformed, besides the method shown in Fig. 9.

In the above-mentioned conversion processing, an existing test bench description described in an expression of sequential timing by use of delay time is converted into a test bench with a clock signal synchronized description, thereby to obtain a test bench possible on a verification system permitting only the clock signal synchronized input pattern.

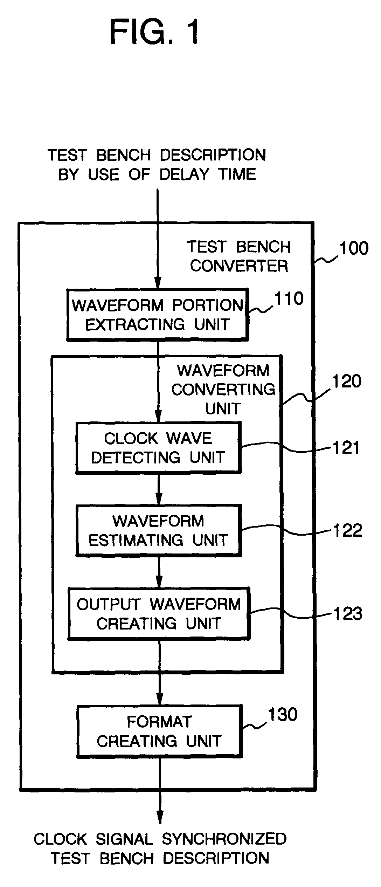

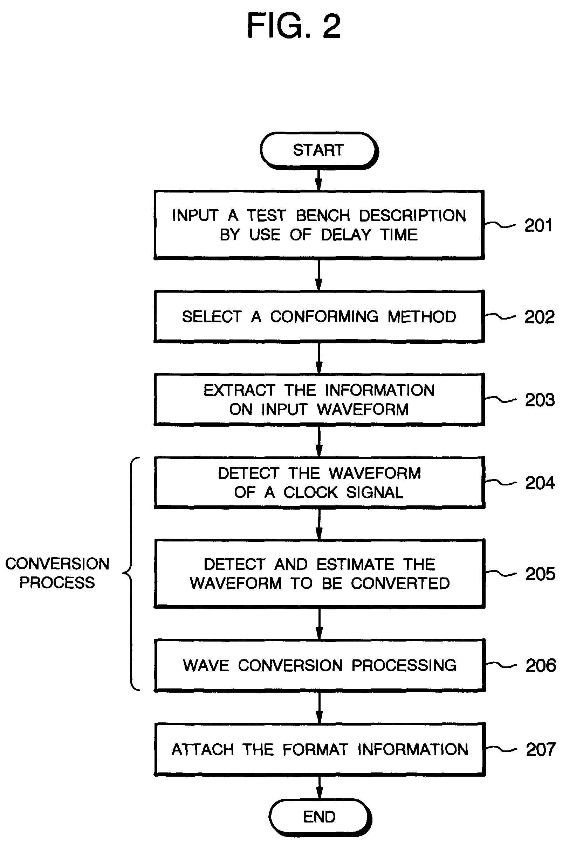

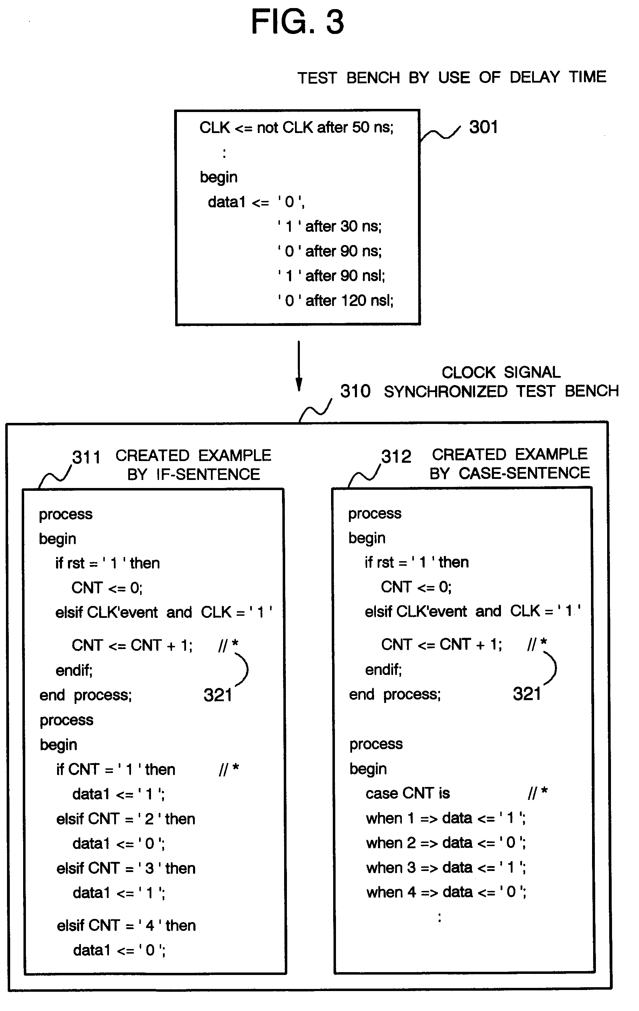

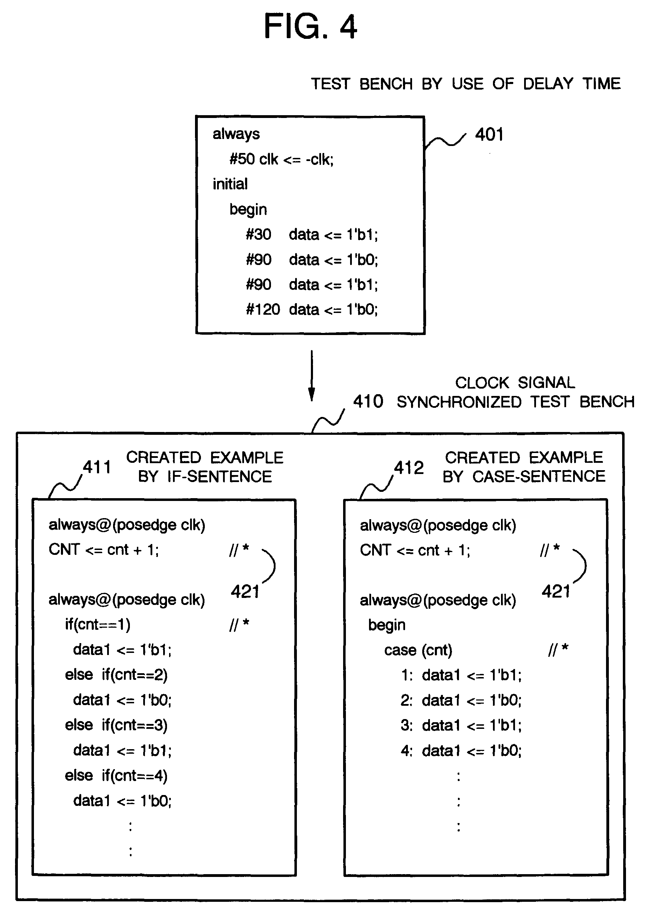

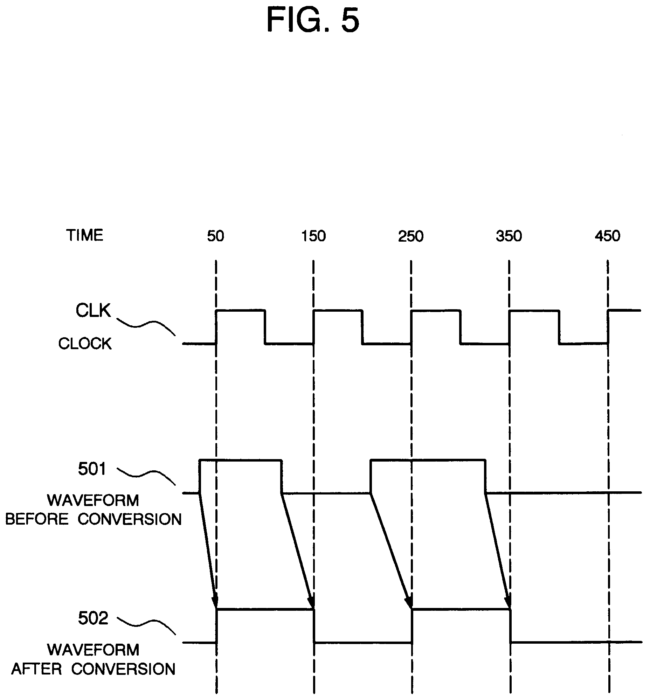

Fig. 1 is a block diagram showing the constitution of a test bench converter according to an embodiment of the present invention, and Fig. 2 is a flow chart showing the procedure of test bench conversion processing according to the embodiment. Fig. 3 shows a conversion example of a test bench format according to the embodiment, Fig. 4 shows another conversion example of a test bench format according to the embodiment, and Fig. 5 is a wave form chart showing the conversion processing of the embodiment by the change of a test pattern.

Referring to Fig. 1, the test bench converter 100 of the embodiment comprises a waveform portion extracting unit 110, receiving a test bench description sequentially described by use of delay time, for extracting waveform information of a test vector from the test bench description, a waveform converting unit 120 for converting the extracted waveform, and a format creating unit 130 for creating a test bench after attaching the given format information to the converted waveform information. The waveform converting unit 120 includes a clock wave detecting unit 121 for detecting the waveform of a clock signal from the waveform information extracted by the waveform portion extracting unit 110, a waveform estimating unit 122 detecting a waveform (test pattern) to be converted from the waveform information for deciding which corresponding change point of the test pattern should be conformed with which change point of a clock signal, and an output waveform creating unit 123 for creating a clock signal synchronized test pattern based on the estimation result by the waveform estimating unit 122. Fig. 1 shows only the characteristic components of the embodiment, and the description of the other general components is omitted there.

The above-mentioned components may be realized by, for example, a program-controlled CPU and an internal memory in a workstation, a personal computer or the other computer system. The control program for controlling the CPU is provided, stored in a magnetic disk, a semiconductor memory, or the other storing medium.

The operation of the embodiment will be described with reference to Fig. 2. A designer enters a test bench description sequentially described in a given hardware description language by use of delay time into the test bench converter 100 at first (Step 201). At this time, assume that the test bench description described in VHDL as the hardware description language is entered. Next, a method for conforming a test pattern with a clock signal is selected (Step 202). As the conforming method of a test pattern, three kinds of methods as shown in Fig. 9 may be selected, or any other method in accordance with the purpose of simulation may be established. Items to be decided in order to describe a test bench in VHDL finally (for example, whether the signal propagation is described in if-sentence or case-sentence) are decided in Step 202.

The waveform portion extracting unit 110 of the test bench converter 100 extracts the information of the waveform portion from the test bench description input in Step 201 and delivers it to the waveform converting unit 120 (Step 203). When the waveform converting unit 120 receives the waveform information, the clock wave detecting unit 121 detects the waveform information of a clock signal at first (Step 204). Detecting the waveform information (test pattern) corresponding to the delay time, that is an object to be converted, the waveform estimating unit 122 decides which change point of the detected test pattern is conformed with which change point of a clock signal according to the selection of a conforming method in Step 202 (Step 205). Converting the waveform according to the decision in Step 205, the output waveform creating unit 123 creates a clock signal synchronized test pattern (Step 206). The state of the waveform conversion is shown in Fig. 5. In the example shown in Fig. 5, a waveform 502, in which each change point of a waveform before conversion 501 is conformed with each rising-up position of a clock signal immediately following, is created.

The format creating unit 130 attaches the format information of VHDL to the new test pattern created by the waveform converting unit 120 (Step 207). Fig. 3 is a view showing the state of attaching the format information to a test pattern. Fig. 3 shows a created example 311 by if-sentence and a created example 312 by case-sentence as a clock signal synchronized test bench description 310 created by conversion of a test bench description 301 using delay time. Referring to Fig. 3, a counter 321 for counting the rising-up clock signal is generated. Instead of using delay time, the generated counter is used to create a description of signal propagation. In order to create a description of signal propagation, there are a method of creating it by if-sentence and a method of creating it by case-sentence, and which method to use is previously determined in Step 202 as mentioned above.

Thus, a test bench description by VHDL synchronized with a clock signal is created.

Also in case of using Verilog HDL as a hardware description language, a test bench by use of delay time can be converted into a clock signal synchronized test bench in the same operation. A conversion example of a test bench in this case is shown in Fig. 4. Referring to Fig. 4, there are shown a created example 411 by if-sentence and a created example 412 by case-sentence as a clock signal synchronized test bench description 410 created by the conversion of a test bench description 401 by use of delay time. In Fig. 4, sentence 421 means a counter.

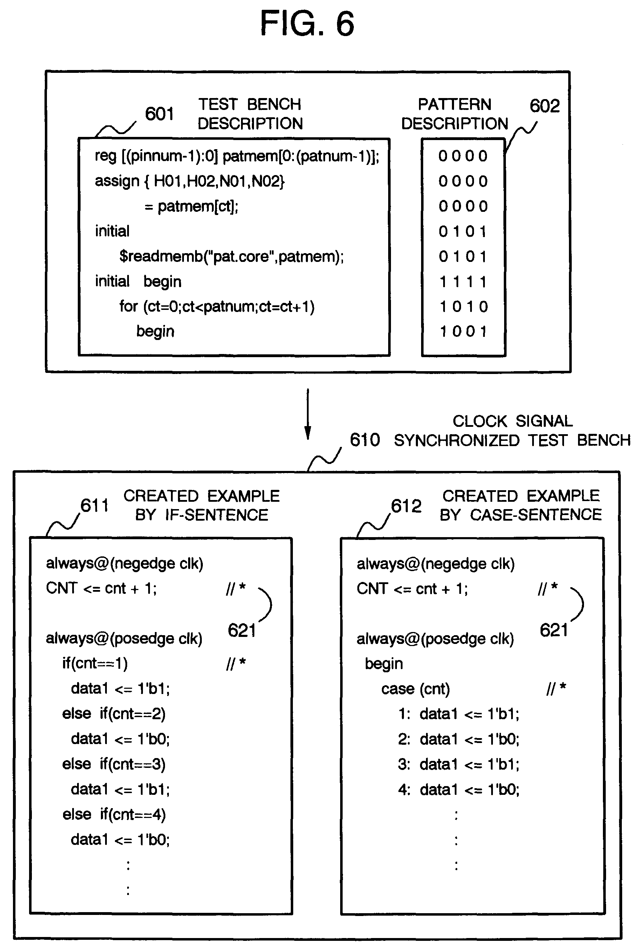

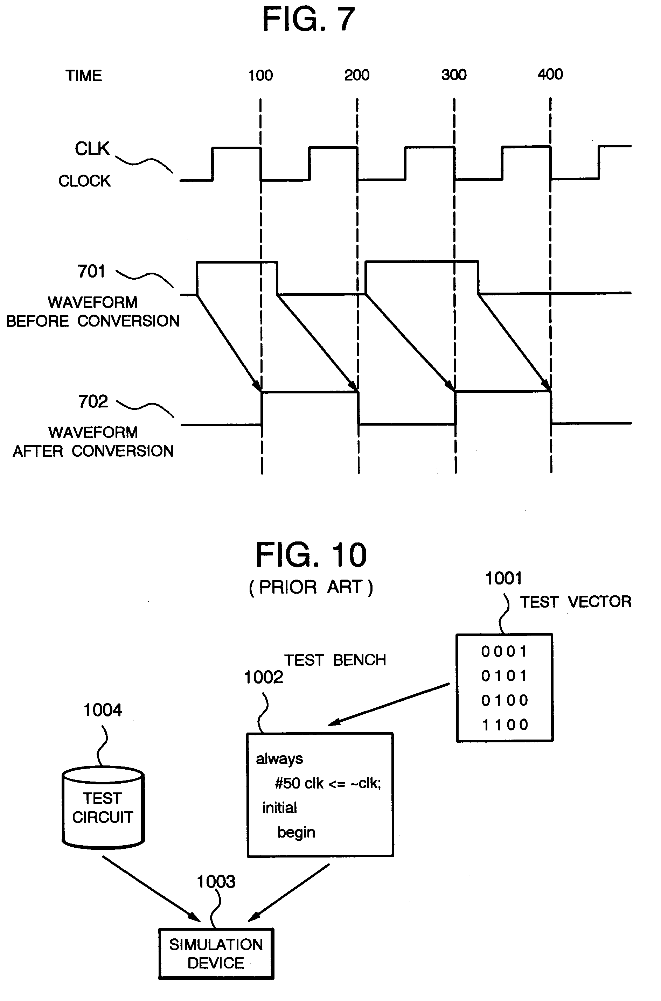

Further, the same processing will be performed when the date entered into the test bench converter 100 includes a pattern description 602 with the expected pattern for making a comparison between the input signal and the output signal for a test vector described in 0 or 1, and a test bench description 601 described in a hardware description language creating the sequential waveform information by use of delay time based on the pattern description 602. The state of this processing is shown in Figs. 6 and 7.

In this case, the test bench description 601 and the pattern description 602 as shown in Fig. 6 are supplied to the test bench converter 100. In this example, the test bench description 601 is supposed to be described in Verilog HDL as a hardware description language. After supplying the test bench description 601 and the pattern description 602 to the test bench converter 100, conforming method of a waveform and other items are decided. Here, the respective change points of a signal are conformed with the falling positions of a clock signal immediately following.

In the test bench converter 100, waveform portion is detected from the test bench description 601 and the pattern description 602, and the clock signal synchronized test bench description 610 is created in the operation having been described with reference to Fig. 2. Similarly to the cases of Figs. 3 and 4, there are a method of creating a description of test pattern signal propagation by if-sentence and a method of creating the same by case-sentence, and which method to use is previously specified.

In the above operation, a test bench description by Verilog HDL synchronized with a clock signal is created. Also in case of using VHDL as a hardware description language, a clock signal synchronized test bench can be created by the conversion of the test bench by using delay time.

As set forth hereinabove, according to the test bench converter and its converting method of the present invention, a test bench described in a sequential expression by use of delay time, for use in supplying a test vector to a simulator, can be converted into a description synchronized with a clock signal. In case of logical verification by a cycle base simulator or a hardware emulator capable of using only a clock signal synchronized test bench, it is not necessary for a designer to create a new clock signal synchronized test bench or manually rewrite an existing test bench using delay time into a clock signal synchronized test bench. Therefore, it can reduce the labor and time extremely in preparation for logical verification.

Further, since the conversion of a test bench is mechanically performed, it is effective in preventing errors on description occurring at the conversion time.

## Claims

1. A test bench converter for creating a test bench described in a hardware description language for supplying a test vector to a simulation device of performing logical verification on a semiconductor integrated circuit by changing a description way of an existing test bench, comprising:
waveform extracting means (110) for extracting description about waveform upon receipt of a test bench description with operations corresponding to signal application to each terminal of a test circuit described by use of delay time;
waveform converting means (120) for converting the waveform extracted by said waveform extracting means (110) into a clock signal synchronized waveform; and
format creating means (130) for creating and supplying a test bench description with operations corresponding to signal application to each terminal of the test circuit described in a clock signal synchronized way after attaching a necessary format to the waveform converted by said waveform converting means (120).

2. A test bench converter as set forth in Claim 1, wherein
said waveform converting means (120) comprising
clock wave detecting means (121) for detecting the waveform of a clock signal, of the waveform extracted by said waveform extracting means (110),
waveform estimating means (122), upon detecting waveform to be converted corresponding to signal application to each terminal of the test circuit, for deciding how to conform the waveform with the waveform of the clock signal, and
waveform creating means (123) for creating a clock signal synchronized waveform based on the decision by said waveform estimating means (122).

3. A test bench converter as set forth in Claim 1, wherein
said format creating means (130) creates a counter for counting rise of a clock signal and creates a signal propagation description by use of the counter instead of delay time.

4. A test bench converter as set forth in Claim 1, wherein
said waveform converting means (120) comprising
clock wave detecting means (121) for detecting a waveform of a clock signal, of the waveform extracted by said waveform extracting means (110),
waveform estimating means (122), upon detecting waveform to be converted corresponding to signal application to each terminal of the test circuit, for deciding how to conform the waveform with the waveform of the clock signal, and
waveform creating means (123) for creating a clock signal synchronized waveform based on the decision by said waveform estimating means (122); and
said format creating means (130)
creates a counter for counting rise of a clock signal and creates a signal propagation description by use of the counter instead of delay time.

5. A test bench converting method for creating a test bench described in a hardware description language for supplying a test vector to a simulation device of performing logical verification on a semiconductor integrated circuit by changing a description way of an existing test bench, comprising the steps of:
a step of extracting description about waveform upon receipt of a test bench description with operations corresponding to signal application to each terminal of a test circuit described by use of delay time;
a step of detecting the waveform of a clock signal, of the extracted waveform;
a step of deciding how to conform the waveform with the waveform of the clock signal, upon detecting the waveform to be converted corresponding to signal application to each terminal of the test circuit;
a step of creating a clock signal synchronized waveform based on the decision; and
a step of creating and supplying a test bench description with operations corresponding to signal application to each terminal of the test circuit described in a clock signal synchronized way after attaching a necessary format to the created waveform.

6. A test bench converting method as set forth in Claim 5, wherein
said format attaching step further comprising
a step of creating a counter for counting rise of a clock signal, and
a step of creating a signal propagation description by use of the counter instead of delay time.

7. A computer readable memory storing a control program for controlling a test bench converter for creating a test bench described in a hardware description language for supplying a test vector to a simulation device of performing logical verification on a semiconductor integrated circuit by changing a description way of an existing test bench, said control program comprising the steps of:
a step of extracting description about waveform portion upon receipt of a test bench description with operations corresponding to signal application to each terminal of a test circuit described by use of delay time;
a step of detecting the waveform of a clock signal, of the extracted waveform portion;
a step of deciding how to conform the waveform portion with the waveform of the clock signal, upon detecting the waveform portion to be converted corresponding to signal application to each terminal of the test circuit;
a step of creating a clock signal synchronized waveform based on the decision; and
a step of creating and supplying a test bench description with operations corresponding to signal application to each terminal of the test circuit described in a clock signal synchronized way after attaching a necessary format to the created waveform.

8. A computer readable memory as set forth in Claim 7, wherein
said format attaching step of the control program further comprising
a step of creating a counter for counting rise of a clock signal, and
a step of creating a signal propagation description by use of the counter instead of delay time.
